(19) Europäisches Patentamt
European Patent Office
Office européen des brevets

(11) **EP 1 565 592 B1**

(12) **EUROPÄISCHE PATENTSCHRIFT**

(45) Veröffentlichungstag und Bekanntmachung des Hinweises auf die Patenterteilung:
**17.01.2007   Patentblatt 2007/03**

(21) Anmeldenummer: **03767442.1**

(22) Anmeldetag: **20.11.2003**

(51) Int Cl.:
***C23C 16/44*** (2006.01)

(86) Internationale Anmeldenummer:
**PCT/DE2003/003846**

(87) Internationale Veröffentlichungsnummer:
**WO 2004/050936 (17.06.2004 Gazette 2004/25)**

(54) **VERFAHREN ZUM REINIGEN EINER PROZESSKAMMER**

METHOD FOR CLEANING A PROCESS CHAMBER

PROCEDE DE NETTOYAGE D'UNE CHAMBRE DE PROCESSUS

(84) Benannte Vertragsstaaten:
**DE FR IT**

(30) Priorität: **30.11.2002   DE 10255988**

(43) Veröffentlichungstag der Anmeldung:
**24.08.2005   Patentblatt 2005/34**

(73) Patentinhaber: **Infineon Technologies AG**
**81669 München (DE)**

(72) Erfinder:
 • **HÖCKELE, Uwe**
  **93053 Regensburg (DE)**
 • **JOHNSON, Andrew**
  **Doylestown, PA 18901 (US)**
 • **KESSLER, Hans-Georg**
  **01109 Dresden (DE)**
 • **NOWIK, Orest**
  **80804 München (DE)**
 • **SCHREIBER, Kai-Alexander**
  **A-9500 Villach (AT)**
 • **WINZIG, Hubert**
  **86163 Augsburg (DE)**
 • **SISTERN, Mark, Ian**
  **Crewe, Cheshire CM1 6BT (GB)**

(74) Vertreter: **Kindermann, Peter et al**
**Kindermann Patentanwälte**
**Postfach 10 02 34**
**85593 Baldham (DE)**

(56) Entgegenhaltungen:
**EP-A- 0 464 696          EP-A- 1 127 957**
**WO-A-02/25713          WO-A-02/086192**
**US-A- 6 060 397          US-A- 6 068 729**
**US-A1- 2002 192 972     US-B1- 6 242 359**

 • **PATENT ABSTRACTS OF JAPAN vol. 1998, no. 03, 27. Februar 1998 (1998-02-27) & JP 09 296271 A (SAMUKO INTERNATL KENKYUSHO:KK), 18. November 1997 (1997-11-18)**
 • **CHARLES ALLGOOD ET AL.: "Evaluation of octafluorocyclobutane as a chamber clean gas in a plasma-enhanced silicon dioxide chemical vapor deposition reactor" JOURNAL OF THE ELECTROCHEMICAL SOCIETY, Bd. 150, Nr. 2, 2003, Seiten G122-G126, XP002280013**
 • **JI HWANG KIM ET AL.: "C4F8O/O2/N-based additive gases for silicon nitride plasma enhanced chemical vapor deposition chamber cleaning with low global warming potentials" JAPANESE JOURNAL OF APPLIED PHYSICS, Bd. 41, 2002, Seiten 6570-6573, XP002280014**

**Beschreibung**

Die Erfindung betrifft ein Verfahren, bei dem in einer Normalbetriebsart der Prozesskammer eine siliziumhaltige Schicht auf einem in die Prozesskammer eingebrachten Halbzeug entsteht. Das Halbzeug wird nach der Schichterzeugung wieder aus der Prozesskammer entfernt. In der Normalbetriebsart entstehen bei der Bearbeitung der Halbzeuge außerdem auch siliziumhaltige Ablagerungen an Kammerwänden der Prozesskammer bzw. an Aufbauten in der Prozesskammer. Diese Ablagerungen müssen nach einem bestimmten Durchsatz an Halbzeugen in einer Reinigungsbetriebsart entfernt werden. In der Reinigungsbetriebsart werden die Ablagerungen unter Verwendung eines Reinigungsgasgemisches entfernt, das beim Eintritt in die Prozesskammer fluorhaltige Verbindungen, d.h. vollfluorierte oder teilfluorierte Verbindungen, und Zusatzverbindungen enthält.

Die Prozesskammer ist insbesondere eine PECVD-Prozesskammer (Plasma Enhanced Chemical Vapor Deposition). In einer solchen Prozesskammer werden aus den Teilchen des Ätzgases mit Hilfe eines Plasmas Ionen, Radikale sowie angeregte Atome und Moleküle erzeugt, um die zur Ätzung führenden chemischen Reaktionen zu beschleunigen. Die so angeregten Teilchen sind aber im Vergleich zu einem PVD-Verfahren (Physical Vapor Deposition) kaum gerichtet. Andererseits lässt sich beispielsweise auch eine SACVD-Prozesskammer einsetzen (Sub Atmospheric Chemical Vapor Deposition).

Das Halbzeug ist bspw. ein Halbleiterwafer, insbesondere ein Siliziumwafer. Beispielsweise hat der Wafer einen Durchmesser von 150 mm (Millimetern), von 200 mm oder von 300 mm.

Die fluorhaltigen Verbindungen sind bspw. vollfluorierte oder teilfluorierte Fluorkohlenstoffe bzw. Fluorkohlenwasserstoffe. Fluorkohlenstoffe bzw. Fluorkohlenwasserstoffe sind zum Einen vergleichsweise teure Prozessgase und zum Anderen umweltbelastend.

Aus der Zusammenfassung zur japanischen Patentanmeldung JP 63011674 A ist ein Verfahren zum Reinigen einer Plasma CVD-Kammer (Chemical Vapor Deposition) bekannt, bei dem ein Gasgemisch aus Stickstofftrifluorid NF3 und Argon Ar verwendet wird.

Das Dokument EP 0464696 bzw. das Dokument US 6,060,397 betrifft ein Reinigungsverfahren mit $C_2F_6$ und Sauerstoff im Verhältnis größer als 1:1 bzw. von 1:1. Das US 6,068,729 betrifft ein Reinigungsverfahren mit $C_2F_6$ und Sauerstoff für Drücke im Bereich von 100 Torr ($1,3.10^5$ Pa) bis 700 Torr ($9,3.10^5$ Pa). Das Dokument EP 1127957 nennt ein Reinigungsverfahren mit $C_2F_6$ und Sauerstoff nur mit Bezug auf den Stand der Technik ohne Einzelheiten zu deren Verhältnis anzugeben. Das Dokument JP 09296271 offenbart ein Reinigungsverfahren, dass nur die Möglichkeit erwähnt $C_4F_8$ und Sauerstoff als Reinigungsgase zu verwenden, ohne dass Angaben zum Verhältnis dieser beiden Gase gemacht werden. Die im Dokument angesprochenen Drücke liegen bei 0,5 Torr 67 Pa bzw. 1 Torr (133 Pa). Das Dokument JP 09296271 betrifft außerdem ein Reinigungsverfahren mit $C_2F_6$ und Stickstoffdioxid bei Drücken von einem Torr bzw. von 0,5 Torr (67 Pa).

Das Dokument "$C_4F_8O/0_2$/N-based additive gases for silicon nitride plasma enhanced chemical vapor deposition chamber cleaning with low global warming potentials", Kim, J. H., et al, Jpn. J. Appl. Phys., Vol. 41 (2002), pp. 6570-6573, betrifft $C_4F_8O$.

Außerdem wird auf die nicht vorveröffentlichte US 2002/0192972 A1 hingewiesen, gemäß der bei einem Druck von etwa 150 Millitorr (20 Pa) ein Gasgemisch aus $C_4F_8$ und $O_2$ zur Reinigung einer Plasmaprozesskammer verwendet wird.

Es ist Aufgabe der Erfindung zum Betreiben einer Prozesskammer, insbesondere einer PECVD-Prozesskammer oder SACVD-Prozesskammer, ein einfaches Verfahren anzugeben, das insbesondere kostengünstig und umweltfreundlich ausgeführt werden kann.

Diese Aufgabe wird durch ein Verfahren mit den in den Patentansprüchen 1 und 10 angegebenen Verfahrensschritten gelöst. Weiterbildungen sind in den Unteransprüchen angegeben.

Die fluorhaltigen Verbindungen sind zu mehr als fünfzig Prozent oder zu mehr als neunzig Prozent Verbindungen mit jeweils mehr als einem Kohlenstoffatom. Dabei beziehen sich die Prozentangaben auf Volumenanteile im Prozessgas beim Eintritt in die Prozesskammer. Die Obergrenze für die Anzahl der Kohlenstoffatome je Verbindung ist durch das Erfordernis gegeben, dass die Verbindungen beim Reinigen gasförmig vorliegen sollen. So liegt die Obergrenze bspw. bei sechs, sieben oder acht Kohlenstoffatomen. Bei einer Ausgestaltung enthalten die fluorhaltige Verbindungen mehr als ein Fluoratom.

Die Zusatzverbindungen sind zu mehr als fünfzig Prozent oder zu mehr als neunzig Prozent Verbindungen mit jeweils mindestens einem Sauerstoffatom. Auch hier beziehen sich die Prozentangaben auf Volumenanteile.

Dies bedeutet, dass beim erfindungsgemäßen Verfahren insbesondere kein Tetrafluorkohlenstoff $CF_4$ eingesetzt wird. Diese Verbindung ist nämlich im Vergleich zu anderen Fluor-Kohlenstoff-Verbindungen chemisch vergleichsweise stabil und führt deshalb zu hohen Emissionen von sogenannten polyfluorierten Verbindungen (PFC - Poly Fluorinated Compounds), d.h. Verbindungen mit mehr als einem Fluoratom. Beim erfindungsgemäßen Verfahren lässt sich die Gasausnutzung z.B. für Verfahren mit Oktafluorzyklobutan $C_4F_8$ auf Werte zwischen achtzig Prozent und neunzig Prozent erhöhen.

Im Vergleich zu einem Prozess mit Tetrafluorkohlenstoff $CF_4$ lassen sich durch den Einsatz des erfindungsgemäßen Verfahrens:

- die Reinigungszeiten um bis zu dreißig Prozent senken, so dass Stillstandszeiten der Prozesskammer verringert werden bzw. bei gleichbleibender Produktionsmenge weniger Prozesskammern erforderlich sind.
- die PFC-Emissionen um bis zu neunzig Prozent senken, so dass strengere Umweltauflagen erfüllbar sind und so dass kleinere Abgasreinigungsanlagen als bisher erforderlich sind. Gegebenenfalls kann die Abgasreinigungsanlage sogar entfallen.
- der Gasverbrauch um 85 Gewichtsprozent verringern, so dass die Kosten um bis zu 60 Prozent sinken ohne dass dabei die Reinigungswirkung beeinträchtigt wird.

Außerdem ermöglichen die Zusatzverbindungen beim erfindungsgemäßen Verfahren eine Optimierung der Ätzrate. Dabei gilt, dass die Ätzrate mit zunehmender Anzahl von Kohlenstoffatomen in den Fluorverbindungen ihr Maximum bei zunehmendem Sauerstoffgehalt im Reinigungsgas erreicht. Die Ätzrate beeinflusst die Reinigungszeit erheblich bei konstanten anderen Parametern, insbesondere bei konstanter Plasmaleistung.

Im Verfahren nach Anspruch 1 ist die Fluorverbindung Oktafluorzyklobutan $C_4F_8$. Das Verhältnis der Anzahl der Fluorverbindungen zur Anzahl der Zusatzverbindungen im Reinigungsgas ist bei diesen Weiterbildungen insbesondere kleiner als 1:8 jedoch größer als 1:20.

Dieses Verfahren betrifft einen Reinigungsprozess, der durch die in der folgenden Tabelle angegebenen Prozessparameter und Emissionen charakterisiert ist:

| Tabelle 1 | $C_4F_8$ - Reinigungsverfahren |
|---|---|
| PFC (sccm) | 300 |
| $N_2O$ (sccm) | 3000 |
| Druck (Torr) | 2,9 (386 Pa) |
| RF Leistung (Watt) | 1000 |
| Reinigungszeit (s) | 76 |
| $SiF_4$-Emission (scc) | 203 |
| $CF_4$-Emission (scc) | 144 |
| $C_2F_6$-Emission (scc) | 0 |
| $C_4F_8$-Emission (scc) | 307 |
| PFC x 10^-9 (MMTCE) | 7,54 |
| Gasverbrauch (g) | 5,4 |

Der Gasfluss des $C_4F_8$-Gases beträgt 300 sccm. Der Gasfluss des Zusatzgases Distickstoffoxid $N_2O$ beträgt 3000 sccm. Bei der Weiterbildung beträgt das Verhältnis der Gasflussraten 1:10.

Die Einheit sccm bedeutet Standard Kubikzentimeter pro Minute bei Normaldruck und bei Normaltemperatur. Als Normaldruck wird der Luftdruck auf Meeresniveau verwendet, d.h. ein Druck von 1013,2 hPa (Hektopascal). Als Normaltemperatur wird hier eine Temperatur von 20 °C (Grad Celsius) bzw. von 293,15 K (Grad Kelvin) angesehen.

Auch eine Angabe in Volumenprozent ist möglich. So sind im Reinigungsgas zehn Volumenprozent Oktafluorzyklobutan $C_4F_8$ und neunzig Volumenprozent Distickstoffoxid $N_2O$ enthalten.

Der Druck in der Reinigungskammer liegt bei 2,9 Torr bzw. 386 Pa (Pascal). Zum Erreichen einer ausreichend hohen Ätzrate beträgt die in die Prozesskammer während der Reinigung zur Erzeugung eines Plasmas eingekoppelte Leistung 1000 Watt. Beispielsweise ergibt sich für eine silanbasierte Siliziumnitridschicht $SiN_x$, z.B. $Si_3N_4$, einer Dicke von 1,46 $\mu$m (Mikrometern) eine Reinigungszeit von 76 s (Sekunden), d.h. eine sehr kurze Reinigungszeit.

Die Emission von Siliziumtetrafluorid $SiF_4$ ist ein Maß für den Fortgang des Reinigungsprozesses. Bei der Weiterbildung werden während des Reinigungsprozesses 203 scc (standard cubic centimeter) Siliziumtetrafluorid $SiF_4$ ausgestoßen, d.h. ein vergleichsweise hoher Wert. Außerdem entstehen 144 scc Tetrafluorkohlenstoff $CF_4$ und 307 scc Oktafluorzyklobutan $C_4F_8$. Die erzeugt Menge an Hexafluorethan $C_2F_6$ ist vernachlässigbar klein.

Aus den Emissionswerten lässt sich ein Maß MMTCE (Million Metric Tons Carbon Equivalent) nach der folgenden Formel berechnen:

$$\text{MMTCE} = \text{Summe}(i, Qi(kg) \cdot 12/44 \cdot GWP100) \cdot 10^{\wedge}-9 \qquad (1)$$

wobei i eine Laufvariable ist, die die Anzahl der Kohlenstoffatome in den emittierten Fluor-Kohlenstoff-Verbindungen angibt. So betrifft Q1 die Masse von Tetrafluorkohlenstoff $CF_4$ im Abgas, Q2 die Masse von Hexafluorethan $C_2F_6$ im Abgas, Q3 die Masse von Oktafluorpropan $C_3F_8$ im Abgas, Q4 die Masse Oktafluorzyklobutan $C_4F_8$, usw. Die Größe GWP100 bezeichnet ein hundertjähriges globales Erwärmungspotential der jeweiligen Fluorverbindung. Es wurde aus der Literatur entnommen, dass das globale Erwärmungspotential GWP100 von Tetrafluorkohlenstoff $CF_4$, Hexafluorethan $C_2F_6$ bzw. von Oktafluorzyklobutan $C_4F_8$ bei 6500, 9200 bzw. 8700 liegt.

Das emittierte Volumen der Fluor-Kohlenstoff-Verbindungen lässt sich von scc unter Verwendung der Molekulargewichte in eine Masse umrechnen, wobei $CF_4$ ein Molekulargewicht von 88 amu (atomic mass unit), $C_2F_6$ ein Molekulargewicht 138 amu und $C_4F_8$ ein Molekulargewicht von 200 amu hat. Es ergibt sich ein Wert von 7,54 10^-9 MMTCE, d.h. ein vergleichsweise kleiner Wert. Der Gesamtgasverbrauch liegt bei 5,4 g (Gramm) für den gesamten Reinigungsprozess. Dies ist ebenfalls ein sehr kleiner Wert.

In einer anderen Variante wird ein Reinigungsprozess durchgeführt, der durch die in der folgenden Tabelle angegebenen Prozessparameter und Emissionen charakterisiert ist:

| Tabelle 2 | $C_4F_8$ - Reinigungsverfahren |
|---|---|
| PFC (sccm) | 150 |
| $N_2O$ (sccm) | 1800 |
| Druck (Torr) | 3,5 (466 Pa) |
| RF Leistung (Watt) | 1000 |
| Reinigungszeit (s) | 105 |
| $SiF_4$-Emission (scc) | 210 |
| $CF_4$-Emission (scc) | 64 |
| $C_2F_6$-Emission (scc) | 0 |
| $C_4F_8$-Emission (scc) | 141 |
| PFC x 10^-9 (MMTCE) | 3,46 |
| Gasverbrauch (g) | 2,7 |

Es wird eine Gasflussrate von 150 sccm für Oktafluorzyklobutan $C_4F_8$ sowie eine Gasflussrate von 1800 sccm für Distickstoffoxid $N_2O$ verwendet. Das bedeutet, dass das Verhältnis der Gasflussraten bei 1:12 liegt.

Auch eine Angabe in Volumenprozent ist möglich. So sind bei der Weiterbildung im Reinigungsgas acht Volumenprozent Oktafluorzyklobutan $C_4F_8$ und zweiundneunzig Volumenprozent Distickstoffoxid $N_2O$ enthalten.

Während der Reinigung herrscht bei der Weiterbildung in der Prozesskammer ein Druck von 3,5 Torr, d.h. von 466 Pa. Die zur Erzeugung des Plasmas während der Reinigung eingekoppelte Leistung liegt wieder bei 1000 Watt.

Es ergibt sich eine ausreichend kleine Reinigungszeit von 105 s für die oben genannte Schicht aus Siliziumnitrid. Diese Zeit liegt etwas über der Reinigungszeit des Reinigungsprozesses gemäß Tabelle 1.

Die Emission von Siliziumtetrafluorid $SiF_4$ liegt bei 210 scc. Die Emission von Tetrafluorkohlenstoff $CF_4$ liegt bei 64 scc. Hexafluorethan $C_2F_6$ wird nur in vernachlässigbar kleinen Mengen bzw. nicht emittiert. Die Emission von Oktafluorzyklobutan $C_4F_8$ liegt bei 141 scc. Aus diesen Werten berechnet sich gemäß der Formel (1) ein Äquivalent MMTCE von 3,46 10^-9, d.h. ein kleineres Äquivalent als bei einem Prozess gemäß der Tabelle 1. Der Gasverbrauch liegt bei nur 2,7 g, d.h. weit unterhalb des Gasverbrauches bei einem Prozess gemäß Tabelle 1.

Im Verfahren nach Anspruch 10 wird als Fluorverbindung Hexafluorethan $C_2F_6$ eingesetzt.

Zum Beispiel ist das Reinigungsverfahren durch die in der folgenden Tabelle angegebenen Prozessparameter und Emissionen charakterisiert:

| Tabelle 3 | $C_2F_6$ - Reinigungsverfahren |
|---|---|
| PFC (sccm) | 300 |

(fortgesetzt)

| Tabelle 3 | $C_2F_6$ - Reinigungsverfahren |
|---|---|
| $N_2O$ (sccm) | 750 |
| Druck (Torr) . | 3,5 (466 Pa) |
| RF Leistung (Watt) | 800 |
| Reinigungszeit (s) | 82 |
| $SiF_4$-Emission (scc) | 203 |
| $CF_4$-Emission (scc) | 131 |
| $C_2F_6$-Emission (scc) | 446 |
| $C_4F_8$-Emission (scc) | 0 |
| PFC x 10^-9 (MMTCE) | 7,78 |
| Gasverbrauch (g) | 3,7 |

Die Gasflussrate für Hexafluorethan $C_2F_6$ liegt bei 300 sccm. Die Gasflussrate für Distickstoffoxid $N_2O$ liegt bei 750 sccm. Damit ergibt sich ein Gasflussratenverhältnis von 1:2,5.

Auch eine Angabe in Volumenprozent ist möglich. So sind bei der Weiterbildung im Reinigungsgas neunundzwanzig Volumenprozent Hexafluorethan $C_2F_6$ und einundsiebzig Volumenprozent Distickstoffoxid $N_2O$ enthalten.

Der Druck in der Prozesskammer beträgt während der Reinigung 3,5 Torr, d.h. 466 Pa. Die zur Erzeugung des Plasmas eingekoppelte Leistung liegt bei 800 Watt.

Mit diesen Prozessparametern ergibt sich eine. Reinigungszeit von 82 s für die oben genannte Schicht aus Siliziumnitrid.

Die Emission von Siliziumtetrafluorid $SiF_4$ liegt bei 203 scc. Die Emission von Tetrafluorkohlenstoff $CF_4$ liegt bei 131 scc. Die Emission von Hexafluorethan $C_2F_6$ liegt bei 446 scc. Oktafluorzyklobutan $C_4F_8$ wird nur in vernachlässigbar kleinen Mengen bzw. nicht emittiert. Aus diesen Werten berechnet sich gemäß der Formel (1) ein Äquivalent MMTCE von 7,78 10^-9, d.h. wieder ein kleineres Äquivalent als bei einem Prozess gemäß der Tabelle 1. Der Gasverbrauch liegt bei. 3,7 g.

Die Werte der oben angegebenen Tabellen 1 bis 3 beziehen sich auf eine Prozesskammer mit einem Prozessraumvolumen wie es bspw. in einer Anlage vom Typ AMAT (Applied Materials) P5000 DxL (lamp heated) vorhanden ist, d.h. auf ein.Prozesskammervolumen von 4,6 Litern. Die angegebenen Werte bleiben auch für etwas größere oder etwas kleinere Prozesskammern gültig, z.B. für Prozesskammern, deren Prozessraumvolumen um bis zu 10 Prozent größer oder kleiner ist. Ähnlich gute Ergebnisse, wie oben angegeben, lassen sich auch erreichen, wenn die Gasflussraten, der Druck bzw. die eingekoppelte Leistung bei den genannten Prozesskammervolumina etwas von den angegebenen Werten abweichen, bspw. in einem Bereich von plus zehn Prozent oder von minus zehn Prozent.

Wird eine Prozesskammer mit einer stärker abweichenden Prozesskammergeometrie eingesetzt, bspw. eine Anlage vom Typ A-MAT (Applied Materials) P5000 DxZ (inductive heated) mit einem Prozesskammervolumen von 6,4 Litern, so lassen sich die in den Tabellen angegebenen Werte in geeignete Werte umrechnen. Die eingekoppelte Leistungsdichte des Plasmas soll gleich bleiben. Die Gasflussraten werden im Verhältnis der Prozessraumgrößen verändert. Der Druck kann unverändert bleiben.

Wird die siliziumhaltige Schicht mit einem silanbasierten Verfahren erzeugt, so sind als Prozessgase sowohl Oktafluorzyklobutan $C_4F_8$ als auch Hexafluorethan $C_2F_6$ geeignet. Wird die siliziumhaltige Schicht mit einem TEOS-Verfahren (Tetra Ethyl Ortho Silicate) erzeugt, so eignet sich als Prozessgas Hexafluorethan $C_2F_6$, und Oktafluorzyklobutan $C_4F_8$.

Das erfindungsgemäße Verfahren und seine Weiterbildungen eignen sich insbesondere zum Reinigen einer Prozesskammer in der sich eine Siliziumnitridschicht $Si_3N_4$, eine undotierte Siliziumdioxidschicht $SiO_2$ oder eine dotierte Siliziumdioxidschicht $SiO_2$ abgelagert hat.

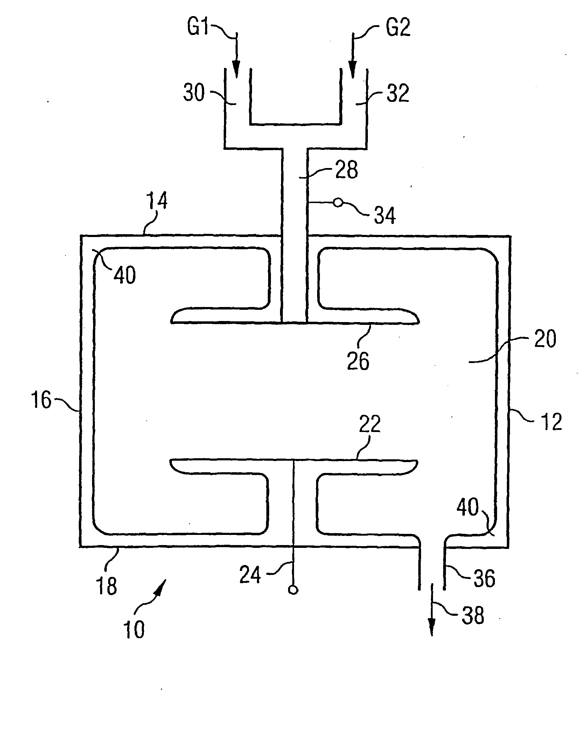

Im Folgenden werden Ausführungsbeispiele der Erfindung an Hand der beiliegenden Zeichnung erläutert. Figur 1 zeigt eine PECVD-Reaktionskammer 10, die einen von Kammerwänden 12 bis 18 umgebenen Reaktionsraum 20 enthält. Der Reaktionsraum 20 ist bspw. zylinderförmig.

In dem Reaktionsraum 20 befindet sich eine Waferhalteeinrichtung 22, die gleichzeitig als Elektrode ausgebildet ist und die mit einem unteren Elektrodenanschluss 24 elektrisch verbunden ist.

Oberhalb der Waferhalteeinrichtung 22 ist ein Gaseinlasskopf 26 angeordnet, der beispielsweise mehrere hundert Gaseintrittsöffnungen enthält. Der Gaseinlasskopf 26 ist mit einer Gaseinlassleitung 28 verbunden. Zur Gaseinlassleitung 28 führen u.a. zwei Gasleitungen 30 und 32 zum Einlassen eines Prozessgases G1 bzw. eines Prozessgases G2. Der Gaseinlasskopf 26 dient außerdem als obere Elektrode, siehe oberen Elektrodenanschluss 34.

Die Reaktionskammer 10 enthält außerdem eine Gasauslassleitung 36, durch die Abgase 38 aus dem Reaktionsraum 20 entfernt werden. Die Gasauslassleitung 26 führt zu einer nicht dargestellten Pumpe, die einen Unterdruck im Reaktionsraum 20 erzeugt. Der Pumpe nachgeschaltet sind Abgasreinigungsvorrichtungen, in denen bspw. eine Verbrennung und ein Waschprozess stattfinden.

In einer Normalbetriebsart wird auf Wafern, die auf der Waferhaltevorrichtung 22 gehalten werden bspw. eine dünne Siliziumnitridschicht erzeugt. Dabei werden bspw. Silan $SiH_4$ und eine Stickstoffkomponente verwendet. Es bildet sich auch an den Kammerwänden 12 bis 18 eine Ablagerungsschicht 40, die von Zeit zu Zeit mit Hilfe eines Reinigungsverfahrens in einer Reinigungsbetriebsart wieder entfernt werden muss. Dadurch wird ein Abplatzen von Teilen der Ablagerungsschicht 40 vermieden; so dass die Defektdichte auf den Wafern besser kontrollierbar ist.

Bei drei Ausführungsbeispielen werden die oben in den drei Tabellen 1 bis 3 charakterisierten Prozesse als Reinigungsprozesse in einer Anlage vom Typ AMAT P5000 DxL ausgeführt. Beispielsweise ist für den Reinigungsprozess gemäß Tabelle 1 das Prozessgas G1 Oktafluorzyklobutan $C_4F_8$. Das Prozessgas G2 ist Distickstoffoxid $N_2O$. Mit Hilfe von nicht dargestellten Masseflussreglern in den Gasleitungen 30 bzw. 32 werden die in der Tabelle 1 angegebenen Gasflussraten von 300 sccm für Oktafluorzyklobutan $C_4F_8$ und 3000 sccm für Distickstoffoxid $N_2O$ eingestellt. Mit Hilfe der Elektrodenanschlüsse 24 und 34 wird zwischen der Waferhaltevorrichtung 22 und dem Gaseinlasskopf 26 ein Plasma erzeugt. Nach dem Zünden des Plasmas wird während der Reinigung eine elektrische Leistung von 1000 Watt eingekoppelt. Ein in die Gasauslassleitung 36 eingebautes Drosselventil wird so angesteuert, dass in dem Reaktionsraum 20 ein Druck von 386 Pa erzeugt wird.

Durch das Plasma werden die Oktafluorzyklobutan-Moleküle $C_4F_8$ in reaktive Radikale aufgespalten. Die Radikale reagieren mit dem Siliziumnitrid in der Ablagerungsschicht 40 zu Siliziumtetrafluorid $SiF_4$, das durch die Gasauslassleitung 36 aus dem Reaktionsraum 20 abgesaugt wird. Die Stickstoffatome in der Ablagerungsschicht 40 bilden Stickstoff $N_2$ oder gasförmige Stickstoffverbindungen wie Stickstoffmonoxid NO und werden ebenfalls über die Gasauslassleitung 36 abgesaugt. Der Sauerstoff der Distickstoffoxid-Verbindungen $N_2O$ reagiert mit dem Kohlenstoff der Radikale bspw. zu Kohlendioxid oder zu Kohlenmonoxid. Dadurch wird die Bildung von Polymeren verhindert, welche die Ätzrate verringern würden.

Die zur Erzeugung des Plasmas eingekoppelte Leistung liegt bei allen drei Ausführungsbeispielen im Bereich zwischen 700 und 1200 Watt. Leistungen über 1200 Watt erfordern umfangreiche Kühlmaßnahmen nach der Reinigungsbetriebsart. Leistungen unterhalb von 700 Watt führen zu stark verlängerten Reinigungszeiten.

Bei einem anderen Ausführungsbeispiel befindet sich der Gaseinlass der Gaseinlassleitung 28 bzw. der Gasauslass in die Gasauslassleitung 36 an einer anderen Stelle als in Figur 1 dargestellt.

Die Temperatur im Reaktionsraum 20 stellt sich auf Grund der vorgegebenen Prozessparameter auf Werte zwischen 300°C (Grad Celsius) und 500°C ein, bspw. auf einen Wert von 400°C.

**Patentansprüche**

1. Verfahren zum Reinigen einer Prozesskammer (10),
bei dem in einer Normalbetriebsart der Prozesskammer (10) eine siliziumhaltige Schicht auf einem in die Prozesskammer (10) eingebrachten Halbzeug entsteht,
bei dem in der Normalbetriebsart siliziumhaltige Ablagerungen (40) an Kammerwänden (16 bis 18) der Prozesskammer (10) und/oder an Aufbauten (22) in der Prozesskammer (10) entstehen,
bei dem in einer Reinigungsbetriebsart die Ablagerungen (40) unter Verwendung eines Reinigungsgasgemisches (G1, G2) entfernt werden, das beim Eintritt in die Prozesskammer (10) fluorhaltige Verbindungen (G1) und Zusatzverbindungen (G2) enthält,
wobei die fluorhaltigen Verbindungen (G1) zu mindestens fünfzig Prozent Verbindungen sind, die jeweils mehr als ein Kohlenstoffatom enthalten,
wobei die Zusatzverbindungen (G2) zu mindestens fünfzig Prozent Verbindungen sind, die jeweils mindestens ein Sauerstoffatom enthalten,
und wobei die Fluorverbindungen (G1) zu mindestens fünfzig Prozent $C_4F_8$-Moleküle sind,
**dadurch gekennzeichnet , dass** im Reinigungsgas das Verhältnis der Anzahl der $C_4F_8$-Moleküle (G1) zur Anzahl der Zusatzverbindungen (G2) kleiner als 1:8 ist,
und dass der Druck in der Prozesskammer (10) im Bereich zwischen 266 Pa und 665 Pa liegt,
und dass die Zusatzverbindungen (G2) zu mindestens fünfzig Prozent $N_2O$-Moleküle sind.

2. Verfahren nach Anspruch 1, **dadurch gekenn- zeichnet**, dass das Verhältnis größer als 1:15 ist.

**3.** Verfahren nach Anspruch 2, **dadurch gekenn- zeichnet**, dass das Verhältnis im Bereich zwischen 1:8 und 1:12 liegt, und/oder dass der Druck in der Prozesskammer (10) im Bereich zwischen 320 Pa und 440 Pa liegt.

**4.** Verfahren nach Anspruch 2, **dadurch gekenn- zeichnet,** dass das Verhältnis im Bereich zwischen 1:10 und 1:14 liegt, und/oder dass der Druck in der Prozesskammer (10) im Bereich zwischen 440 Pa und 490 Pa liegt.

**5.** Verfahren nach einem der Ansprüche 2 bis 4, **dadurch gekennzeichnet, dass** die Prozesskammer (10) ein Prozessraumvolumen von 4,6 Litern hat oder dass das Prozessraumvolumen von diesem Wert höchstens um zehn Prozent abweicht.

**6.** Verfahren nach Anspruch 5, **dadurch gekenn- zeichnet,** dass in der Prozesskammer (10) in der Reinigungsbetriebsart ein Plasma erzeugt wird, wobei die eingekoppelte Leistung zur Erzeugung des Plasmas vorzugsweise im Bereich von 800 Watt bis 1200 Watt liegt.

**7.** Verfahren nach Anspruch 5 oder 6, **dadurch gekennzeichnet, dass** die Gasflussrate eines die Fluorverbindungen enthaltenden Gases (G1) im Bereich von 200 sccm bis 400 sccm liegt, und das die Gasflussrate eines die Zusatzverbindungen (G2) enthaltenden Gases im Bereich von 2800 sccm bis 3200 sccm liegt.

**8.** Verfahren nach Anspruch 5 oder 6, **dadurch gekennzeichnet, dass** die Gasflussrate eines die Fluorverbindungen enthaltenden Gases (G1) im Bereich von 100 sccm bis 200 sccm liegt, und das die Gasflussrate eines die Zusatzverbindungen (G2) enthaltenden Gases im Bereich von 1600 sccm bis 2000 sccm.

**9.** Verfahren nach einem der Ansprüche 1 bis 4, **dadurch gekennzeichnet, dass** die Prozesskammer (10) ein anderes Prozessraumvolumen als das im Anspruch 5 genannte Prozessraumvolumen hat, und dass in der Prozesskammer (10) in der Reinigungsbetriebsart ein Plasma erzeugt wird, dessen Leistungsdichte gleich der Leistungsdichte eines mit den Leistungswerten gemäß Anspruch 6 erzeugten Plasmas ist, und/oder das die Gasflussrate eines die Fluorverbindungen enthaltenden Gases (G1) und die Gasflussrate eines die Zusatzverbindungen enthaltenden Gases (G2) den mit einem Korrekturfaktor korrigierten Gasflussraten gemäß Anspruch 7 oder 8 gleichen, wobei der Korrekturfaktor das Verhältnis des Volumens des Prozessraums zu dem Volumen des Prozessraumes gemäß Anspruch 5 angibt.

**10.** Verfahren zum Reinigen einer Prozesskammer (10), bei dem in einer Normalbetriebsart der Prozesskammer (10) eine siliziumhaltige Schicht auf einem in die Prozesskammer (10) eingebrachten Halbzeug entsteht, bei dem in der Normalbetriebsart siliziumhaltige Ablagerungen (40) an Kammerwänden (16 bis 18) der Prozesskammer (10) und/oder an Aufbauten (22) in der Prozesskammer (10) entstehen, bei dem in einer Reinigungsbetriebsart die Ablagerungen (40) unter Verwendung eines Reinigungsgasgemisches (G1, G2) entfernt werden, das beim Eintritt in die Prozesskammer (10) fluorhaltige Verbindungen (G1) und Zusatzverbindungen (G2) enthält, wobei die fluorhaltigen Verbindungen (G1) zu mindestens fünfzig Prozent Verbindungen sind, die jeweils mehr als ein Kohlenstoffatom enthalten, wobei die Zusatzverbindungen (G2) zu mindestens fünfzig Prozent Verbindungen sind, die jeweils mindestens ein Sauerstoffatom enthalten, wobei die Fluorverbindungen (G1) zu mindestens fünfzig Prozent $C_2F_6$-Moleküle sind, **dadurch gekennzeichnet, dass** der Druck in der Prozesskammer (10) im Bereich zwischen 266 Pa und 665 Pa liegt, dass die Zusatzverbindungen (G2) zu mindestens fünfzig Prozent $N_2O$-Moleküle sind, und dass im Reinigungsgas das Verhältnis der Anzahl von Fluorverbindungen (G1) zur Anzahl der Zusatzverbindungen (G2) im Bereich zwischen 1:2,3 und 1:2,7 liegt.

**11.** Verfahren nach Anspruch 10, **dadurch gekenn- zeichnet,** dass der Druck in der Prozesskammer (10) im Bereich zwischen 440 Pa und 490 Pa liegt.

**12.** Verfahren nach Anspruch 10 oder 11, **dadurch gekennzeichnet, dass** die Prozesskammer (10) ein Prozessraumvolumen von 5,6 Litern hat oder dass das Prozessraumvolumen von diesem Wert höchstens um zehn Prozent abweicht.

**13.** Verfahren nach Anspruch 12, **dadurch gekennzeichnet, dass** in der Prozesskammer (10) in der Reinigungsbetriebsart ein Plasma erzeugt wird,
wobei die eingekoppelte Leistung zur Erzeugung des Plasmas vorzugsweise im Bereich von 600 Watt bis 1200 Watt liegt.

**14.** Verfahren nach Anspruch 12 oder 13, **dadurch gekennzeichnet, dass** die Gasflussrate eines die Fluorverbindungen enthaltenden Gases (G1) im Bereich von 200 sccm bis 400 sccm liegt,
und das die Gasflussrate eines die Zusatzverbindungen (G2) enthaltenden Gases im Bereich von 600 sccm bis 900 sccm liegt.

**15.** Verfahren nach Anspruch 10 oder 11, **dadurch gekennzeichnet, dass** die Prozesskammer (10) ein anderes Prozessraumvolumen als das im Anspruch 12 genannte Prozessraumvolumen hat,
und dass in der Prozesskammer (10) in der Reinigungsbetriebsart ein Plasma erzeugt wird, dessen Leistungsdichte gleich der Leistungsdichte eines mit den Leistungswerten gemäß Anspruch 13 erzeugten Plasmas ist,
und/oder das die Gasflussrate eines die Fluorverbindungen enthaltenden Gases (G1) und die Gasflussrate eines die Zusatzverbindungen enthaltenden Gases (G2) den mit einem Korrekturfaktor korrigierten Gasflussraten gemäß Anspruch 14 gleichen, wobei der Korrekturfaktor das Verhältnis des Volumens des Prozessraums zu dem Volumen des Prozessraumes gemäß Anspruch 12 angibt.

**16.** Verfahren nach einem der vorherigen Ansprüche, **da- durch gekennzeichnet**, dass die siliziumhaltige Schicht (40) mit einem silanbasierten Verfahren erzeugt wird, oder dass die siliziumhaltige Schicht (40) mit einem TEOS-Verfahren erzeugt wird.

**17.** Verfahren nach einem der vorhergehenden Ansprüche, **dadurch gekennzeichnet, dass** dass die siliziumhaltige Schicht (40) dotiert oder undotiert ist,
und/oder dass die siliziumhaltige Schicht (40) zu mindestens fünfzig Masseprozent Siliziumnitrid oder Siliziumdioxid enthält,
und/oder das das Halbzeug ein Trägersubstrat aus einem Halbleitermaterial, insbesondere aus Silizium ist.

**18.** Verfahren nach Anspruch 1, **dadurch gekennzeichnet, dass** das Verhältnis größer als 1: 20 ist.

**19.** Verfahren nach Anspruch 2, **dadurch gekennzeichnet, dass** das Verhältnis im Bereich zwischen 1:8 und 1:12 liegt,
und/oder dass der Druck in der Prozesskammer (10) im Bereich zwischen 370 Pa und 400 Pa liegt.

**20.** Verfahren nach Anspruch 5 oder 6, **dadurch gekennzeichnet, dass** die Gasflussrate eines die Fluorverbindungen enthaltenden Gases (G1) im Bereich von 200 sccm bis 400 sccm liegt,
und das die Gasflussrate eines die Zusatzverbindungen (G2) enthaltenden Gases im Bereich von 2900 sccm bis 3100 sccm liegt.

**21.** Verfahren nach Anspruch 5 oder 6, **dadurch gekennzeichnet, dass** die Gasflussrate eines die Fluorverbindungen enthaltenden Gases (G1) im Bereich von 100 sccm bis 200 sccm liegt, und das die Gasflussrate eines die Zusatzverbindungen (G2) enthaltenden Gases im Bereich von 1600 sccm bis 2000 sccm oder im Bereich von 1700 sccm bis 1900 sccm liegt.

**Claims**

**1.** Method for cleaning a process chamber (10),
in which, in a normal mode of operation of the process chamber (10), a silicon-containing layer forms on the semifinished product introduced into the process chamber (10),
in which, in the normal mode of operation, silicon-containing deposits (40) form on chamber walls (16 to 18) of the process chamber (10) and/or on structures (22) in the process chamber (10),
in which, in a cleaning mode of operation, the deposits (40) are removed using a cleaning gas mixture (G1, G2) which, on entering the process chamber (10), contains fluorine-containing compounds (G1) and additional compounds (G2),
at least fifty percent of the fluorine-containing compounds (G1) being compounds which in each case contain more than one carbon atom,
at least fifty percent of the additional compounds (G2) being compounds which in each case contain at least one oxygen atom,
and at least fifty percent of the fluorine compounds (G1) being $C_4F_8$ molecules, **characterized in that**
the ratio of the number of $C_4F_8$ molecules (G1) to the number of additional compounds (G2) in the cleaning gas is less than 1:8
and **in that** the pressure in the process chamber (10) is in the range between 266 Pa and 665 Pa
and **in that** at least fifty percent of the (additional) compounds (G2) are $N_2O$ molecules.

2.  Method according to Claim 1, **characterized in that** the ratio is greater than 1:15.

3.  Method according to Claim 2, **characterized in that** the ratio is in the range between 1:8 and 1:12,
    and/or that the pressure in the process chamber (10) is in the range between 320 Pa and 440 Pa.

4.  Method according to Claim 2, **characterized in that** the ratio is in the range between 1:10 and 1:14 and/or **in that**
    the pressure in the process chamber (10) is in the range between 440 Pa and 490 Pa.

5.  Method according to any of Claims 2 to 4,
    **characterized in that** the process chamber (10) has a process space volume of 4.6 litres or that the process space
    volume deviates from this value by not more than ten percent.

6.  Method according to Claim 5, **characterized in that** a plasma is produced in the process chamber (10) in the
    cleaning mode of operation,
    the power input for producing the plasma preferably being in the range of 800 watt to 1 200 watt.

7.  Method according to Claim 5 or 6, **characterized in that** the gas flow rate of the gas (G1) containing the fluorine
    compounds is in the range of 200 sccm to 400 sccm,
    and that the gas flow rate of gas containing the additional compounds (G2) is in the range of 2 800 sccm to 3 200 sccm.

8.  Method according to Claim 5 or 6, **characterized in that** the gas flow rate of a gas (G1) containing the fluorine
    compounds is in the range of 100 sccm to 200 sccm
    and that the gas flow rate of a gas containing the additional compounds (G2) is in the range of 1 600 sccm to 2 000
    sccm.

9.  Method according to any of Claims 1 to 4,
    **characterized in that** the process chamber (10) has a process space volume differing from the process space
    volume mentioned in Claim 5,
    and that a plasma whose power density is the same as the power density of a plasma produced using the power
    values according to Claim 6 is produced in the process chamber (10) in the cleaning mode of operation,
    and/or that the gas flow rate of a gas (G1) containing the fluorine compounds and the gas flow rate of a gas (G2)
    containing the additional compounds are the same as the gas flow rates according to Claim 7 or 8 which are being
    corrected using a correction factor, the correction factor specifying the ratio of the volume of the process space to
    the volume of the process space according to Claim 5.

10. Method for cleaning a process chamber (10),
    in which, in a normal mode of operation of the process chamber (10), a silicon-containing layer forms on a semifinished
    product introduced into the process chamber (10),
    in which, in the normal mode of operation, silicon-containing deposits (40) form on chamber walls (16 to 18) of the
    process chamber (10) and/or on structures (22) in the process chamber (10),
    in which, in a cleaning mode of operation, the deposits (40) are removed using a cleaning gas mixture (G1, G2)
    which, on entering the process chamber (10), contains fluorine-containing compounds (G1) and additional compounds (G2),
    at least fifty percent of the fluorine-containing compounds (G1) being compounds which in each case contain more
    than one carbon atom,
    at least fifty percent of the additional compounds (G2) being compounds which in each case contain at least one
    oxygen atom,
    at least fifty percent of the fluorine compounds (G1) being $C_2F_6$ molecules,
    **characterized in that** the pressure in the process chamber (10) is in the range between 266 Pa and 665 Pa,
    **in that** at least fifty percent of the additional compounds (G2) are $N_2O$ molecules,
    and **in that** the ration of the number of fluorine compounds (G1) to the number of additional compounds (G2) in the cleaning gas is in the range between 1:2.3 and 1:2.7.

11. Method according to Claim 10, **characterized in that** the pressure in the process chamber (10) is in the range between 440 Pa and 490 Pa.

12. Method according to Claim 10 or 11, **characterized in that** the process chamber (10) has a process space volume of 5.6 litres or that the process space volume deviates from this value by not more than ten percent.

13. Method according to Claim 12, **characterized in that** a plasma is produced in the process chamber (10) in the cleaning mode of operation,
the power input for producing the plasma preferably being in the range of 600 watt to 1 200 watt.

14. Method according to Claim 12 or 13, **characterized in that** the gas flow rate of a gas (G1) containing the fluorine compounds is in the range of 200 sccm to 400 sccm, and that the gas flow rate of a gas containing the additional compounds (G2) is in the range of 600 sccm to 900 sccm.

15. Method according to Claim 10 or 11, **characterized in that** the process chamber (10) has a process space volume differing from the process space volume mentioned in Claim 12,
and that a plasma whose power density is the same as the power density of a plasma produced using the power values according to Claim 13 is produced in the process chamber (10) in the cleaning mode of operation,
and/or that the gas flow rate of a gas (G1) containing the fluorine compounds and the gas flow rate of a gas (G2) containing the additional compounds are the same as the gas flow rates according to Claim 14 which have been corrected using a correction factor, the correction factor specifying the ratio of the volume of the process space to the volume of the process space according to Claim 12.

16. Method according to any of the preceding claims,
**characterized in that** the silicon-containing layer (40) is produced by a silane-based process,
or that the silicon-containing layer (40) is produced by a TEOS process.

17. Method according to one of the preceding claims,
**characterized in that** the silicon-containing layer (40) is doped or undoped,
and/or that at least fifty percent by mass of the silicon-containing layer (40) contains silicon nitride or silicon dioxide,
and/or that the semifinished product is a substrate comprising a semiconductor material, in particular comprising silicon.

18. Method according to Claim 1, **characterized in that** the ratio is greater than 1:20.

19. Method according to Claim 2, **characterized in that** the ratio is in the range between 1:8 and 1:12
and/or that the pressure in the process chamber (10) is in the range between 370 Pa and 400 Pa.

20. Method according to Claim 5 or 6, **characterized in that** the gas flow rate of the gas (G1) containing the fluorine compounds is in the range of 200 sccm to 400 sccm,
and that the gas flow rate of the gas containing the additional compounds (G2) is in the range of 2900 sccm to 3100 sccm.

21. Method according to Claim 5 or 6, **characterized in that** the gas flow rate of the gas (G1) containing the fluorine compounds is in the range of 100 sccm to 200 sccm,
and that the gas flow rate of the gas containing the additional compounds (G2) is in the range of 1600 sccm to 2000 sccm or in the range of 1700 sccm to 1900 sccm.

**Revendications**

1. Procédé de nettoyage d'une chambre (10) de processus,
dans lequel il se forme, dans un mode de fonctionnement normal de la chambre (10) de processus, une couche contenant du silicium sur un demi-produit introduit dans la chambre (10) de processus,

dans lequel il se forme, dans le mode normal de fonctionnement, des dépôts (40) contenant du silicium sur les parois (16 à 18) de la chambre (10) de processus et/ou sur des pièces (22) rapportées dans la chambre (10) de processus,

dans lequel on élimine, dans un mode de fonctionnement de nettoyage, les dépôts (40) en utilisant un mélange (G1, G2) gazeux de nettoyage qui contient, à l'entrée dans la chambre (10) de processus, des composés (G1) fluorés et des composés (G2) d'addition,

les composés (G1) fluorés étant pour au moins cinquante pour cent des composés qui contiennent, respectivement, plus d'un atome de carbone,

les composés (G2) d'addition étant pour au moins cinquante pour cent des composés qui contiennent, respectivement, au moins un atome d'oxygène,

et les composés (G1) fluorés étant pour au moins cinquante pour cent des molécules en $C_4F_8$,

**caractérisé en ce que** dans le gaz de nettoyage, le rapport du nombre des molécules (G1) en $C_4F_8$ au nombre des composés (G2) d'addition est inférieur à 1:8

et **en ce que** la pression dans la chambre (10) de processus est dans la plage comprise entre 266 Pa et 665 Pa

et **en ce que** les composés (G2) d'addition sont pour au moins cinquante pour cent des molécules de $N_2O$.

2. Procédé suivant la revendication 1, **caractérisé en ce que** le rapport est supérieur à 1:15.

3. Procédé suivant la revendication 2, **caractérisé en ce que** le rapport est dans la plage comprise entre 1:8 et 1:12 et/ou **en ce que** la pression dans la chambre (10) de processus est dans la plage comprise entre 320 Pa et 440Pa.

4. Procédé suivant la revendication 2, **caractérisé en ce que** le rapport est dans la plage comprise entre 1:10 et 1:14 et/ou **en ce que** la pression dans la chambre (10) de processus est dans la plage comprise entre 440 Pa et 490 Pa.

5. Procédé suivant l'une des revendications 2 à 4, **caractérisé en ce que** la chambre (10) de processus a un volume d'espace de processus de 4,6 litres ou **en ce que** volume d'espace de processus s'écarte de cette valeur au plus de dix pour cent.

6. Procédé suivant la revendication 5, **caractérisé en ce qu'**il est produit dans la chambre (10) de processus dans le mode de fonctionnement en nettoyage un plasma, la puissance injectée pour la production du plasma étant, de préférence, dans la plage allant de 800 watts à 1200 watts.

7. Procédé suivant la revendication 5 ou 6, **caractérisé en ce que** le débit d'un gaz (G1) contenant les composés fluorés est dans la plage allant de 200 à 400 cm$^3$ dans les conditions normales et le débit d'un gaz contenant les composés (G2) d'addition est dans la plage allant de 2800 à 3200 cm$^3$ dans les conditions normales.

8. Procédé suivant la revendication 5 ou 6, **caractérisé en ce que** le débit d'un gaz (G1) contenant les composés fluorés est dans la plage allant de 100 à 200 cm$^3$ dans les conditions normales et **en ce que** le débit d'un gaz contenant les composés (G2) d'addition est dans la plage allant de 1600 à 2000 cm$^3$ dans les conditions normales.

9. Procédé suivant l'une des revendications 1 à 4, **caractérisé en ce que** la chambre (10) de processus a un autre volume d'espace de processus que le volume d'espace de processus mentionné à la revendication 5, et **en ce qu'**il est produit dans la chambre (10) de processus, dans le mode de fonctionnement en nettoyage, un plasma dont la densité de puissance est égale à la densité de puissance d'un plasma produit en ayant les valeurs de puissance suivant la revendication 6, et/ou **en ce que** le débit d'un gaz (G1) contenant les composés fluorés et le débit d'un gaz (G2) contenant les composés d'addition sont égaux aux débits suivant la revendication 7 ou 8, corrigés d'un facteur de correction, le facteur de correction indiquant le rapport du volume de l'espace de processus au volume d'espace de processus suivant la revendication 5.

10. Procédé de nettoyage d'une chambre (10) de processus, dans lequel il se forme, dans un mode de fonctionnement normal de la chambre (10) de processus, une couche contenant du silicium sur un demi-produit introduit dans la chambre (10) de processus, dans lequel il se forme, dans le mode normal de fonctionnement, des dépôts (40) contenant du silicium sur les parois (16 à 18) de la chambre (10) de processus et/ou sur des pièces (22) rapportées dans la chambre (10) de processus,

dans lequel on élimine, dans un mode de fonctionnement de nettoyage, les dépôts (40) en utilisant un mélange (G1, G2) gazeux de nettoyage qui contient, à l'entrée dans la chambre (10) de processus, des composés (G1) fluorés et des composés (G2) d'addition,

les composés (G1) fluorés étant pour au moins cinquante pour cent des composés qui contiennent, respectivement, plus d'un atome de carbone,

les composés (G2) d'addition étant pour au moins cinquante pour cent des composés qui contiennent, respectivement, au moins un atome d'oxygène,

et les composés (G1) fluorés étant pour au moins cinquante pour cent des molécules en $C_4F_8$,

**caractérisé en ce que** la pression dans la chambre (10) de processus est dans la plage comprise entre 266 Pa et 665 Pa,

**en ce que** les composés (G2) d'addition sont pour au moins cinquante pour cent des molécules de $N_2O$,

et ce que dans le gaz de nettoyage le rapport du nombre des composés (G1) fluorés au nombre des composés (G2) d'addition est dans la plage comprise entre 1:2,3 et 1:2,7.

**11.** Procédé suivant la revendication 10, **caractérisé en ce que** la pression dans la chambre (10) de processus est dans la plage comprise entre 440 Pa et 490 Pa.

**12.** Procédé suivant la revendication 10 ou 11, **caractérisé en ce que** la chambre (10) de processus a un volume d'espace de processus de 5,6 litres ou **en ce que** le volume d'espace de processus s'écarte de cette valeur au plus de dix pour cent.

**13.** Procédé suivant la revendication 12, **caractérisé en ce qu'**il est produit dans la chambre (10) de processus dans le mode de fonctionnement en nettoyage un plasma,

la puissance injectée pour la production du plasma étant, de préférence, dans la plage allant de 600 watts à 1200 watts.

**14.** Procédé suivant la revendication 12 ou 13, **caractérisé en ce que** le débit d'un gaz (G1) contenant les composés fluorés est dans la plage allant de 200 à 400 cm$^3$ dans les conditions normales

et le débit d'un gaz contenant les composés (G2) d'addition est dans la plage allant de 600 à 900 cm$^3$ dans les conditions normales.

**15.** Procédé suivant la revendication 10 ou 11, **caractérisé en ce que** la chambre (10) de processus a un autre volume d'espace de processus que le volume d'espace de processus mentionné à la revendication 12,

et **en ce qu'**il est produit dans la chambre (10) de processus, dans le mode de fonctionnement en nettoyage, un plasma dont la densité de puissance est égale à la densité de puissance d'un plasma produit en ayant les valeurs de puissance suivant la revendication 13,

et/ou **en ce que** le débit d'un gaz (G1) contenant les composés fluorés et le débit d'un gaz (G2) contenant les composés d'addition sont égaux aux débits suivant la revendication 14, corrigés d'un facteur de correction, le facteur de correction indiquant le rapport du volume de l'espace de processus au volume d'espace de processus suivant la revendication 12.

**16.** Procédé suivant l'une des revendications précédentes, **caractérisé en ce que** l'on produit la couche (40) contenant du silicium par un procédé à base de silane ou **en ce que** l'on produit la couche (40) contenant du silicium par un procédé au TEOS.

**17.** Procédé suivant l'une des revendications précédentes, **caractérisé en ce que** la couche (40) contenant du silicium est dopée ou ne l'est pas

et/ou **en ce que** la couche (40) contenant du silicium contient pour au moins cinquante pour cent en masse du nitrure de silicium ou du dioxyde de silicium

et/ou **en ce que** le demi-produit est un substrat servant de support en un matériau semi-conducteur, notamment en silicium.

**18.** Procédé suivant la revendication 1, **caractérisé en ce que** le rapport est supérieur à 1:20.

**19.** Procédé suivant la revendication 2, **caractérisé en ce que** le rapport est dans la plage comprise entre 1:8 et 1:12 et/ou **en ce que** la pression dans la chambre (10) de processus est dans la plage comprise entre 370 Pa et 400 Pa.

**20.** Procédé suivant la revendication 5 ou 6, **caractérisé en ce que** le débit d'un gaz (G1) contenant les composés fluorés est dans la plage allant de 200 cm$^3$ à 400 cm$^3$ dans les conditions normales
et **en ce que** le débit d'un gaz contenant les composés (G2) d'addition est dans la plage allant de 2900 cm$^3$ à 3100 cm$^3$ dans les conditions normales.

**21.** Procédé suivant la revendication 5 ou 6, **caractérisé en ce que** le débit d'un gaz (G1) contenant les composés fluorés est dans la plage allant de 100 cm$^3$ à 200 cm$^3$ dans les conditions normales
et **en ce que** le débit d'un gaz contenant les composés (G2) d'addition est dans la plage allant de 1600 à 2000 cm$^3$ ou dans la plage allant de 1700 à 1900 cm$^3$ dans les conditions normales.